# EUROPÄISCHE PATENTSCHRIFT

(11) **EP 1 064 724 B1**
(45) Veröffentlichungstag und Bekanntmachung des Hinweises auf die Patenterteilung: **18.10.2006**
(21) Anmeldenummer: 99922063.5
(22) Anmeldetag: 22.03.1999
(51) Int. Cl.: H03H 9/64, H03H 9/02

(54) **AKUSTISCHES OBERFLÄCHENWELLENFILTER**
SURFACE-WAVE ACOUSTIC FILTER
FILTRE ACOUSTIQUE A ONDES DE SURFACE

(30) Priorität: 23.03.1998 DE 19812641
(43) Veröffentlichungstag der Anmeldung: 03.01.2001
(73) Patentinhaber: EPCOS AG, 81669 München (DE)
(72) Erfinder: ALI-HACKL, Markus, D-82110 Germering (DE); FREISLEBEN, Stefan, D-81541 München (DE); JOHANNES, Thomas, D-81925 München (DE); BAIER, Thomas, D-81827 München (DE); BAUERNSCHMITT, Ulrich, D-85748 Garching (DE); RÖSLER, Ulrike, D-85435 Erding (DE)
(74) Vertreter: Epping - Hermann - Fischer
(86) Internationale Anmeldenummer: PCT/DE1999/000843
(87) Internationale Veröffentlichungsnummer: WO 1999/049573

(56) Entgegenhaltungen:
- EP-A- 0 772 293
- EP-A- 0 872 954
- DE-A- 4 214 122
- GB-A- 1 427 226

## Beschreibung

Die Sperrselektion eines Oberflächenwellenfilters, kurz OFW-Filter genannt, wird in hohem Maße durch elektromagnetisches Übersprechen nachteilig beeinflußt. Wesentliche Ursache hierfür sind eng benachbarte Filterstrukturen, insbesondere eng zueinander angrenzende Strukturen der interdigitalen Ein- und Ausgangswandler und ihrer Stromanschlußbahnen, auch Pads genannt.

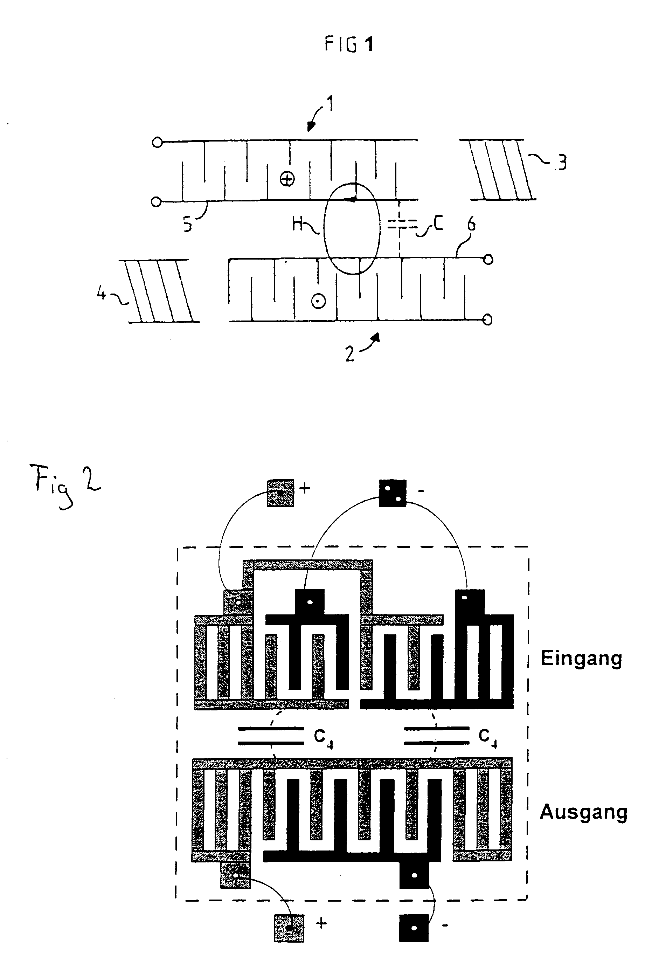

Betrachtet man die übliche, in Fig. 1 schematisch dargestellte Wandler- und Padtopologie der Ein- und Ausgangswandler 1 und 2, z.B. eines Z-Weg-Filters, dessen Reflektoren 3, 4 gleichfalls nur schematisch angedeutet sind, so wird das elektromagnetische Übersprechen durch zwei Mechanismen verursacht. Und zwar zum einen durch kapazitives Übersprechen zwischen dicht benachbarten Pads 5 und 6 - was durch eine strichliniert angedeutete Ersatzschaltbildkapazität "C" zwischen den Pads symbolisiert ist, und zum anderen durch induktives Übersprechen, was in Fig. 1 wiederum durch Magnetfeldlinien H symbolisiert ist, die teils durch einen Pfeil gekennzeichnete benachbarte Stromflußlinien umschließen.

In der Regel treten beide Mechanismen, d.h. induktives und kapazitives Übersprechen, gleichzeitig auf. Ihre jeweiligen Anteile am elektromagnetischen Übersprechen hängen von den Filterparametern ab, wobei bei hohen Frequenzen und niedrigeren Impedanzen zunehmend induktives Übersprechen an Bedeutung erlangt.

Typische OFW-Filter, deren Sperrselektion durch elektromagnetisches Übersprechen erheblich beeinträchtigt wird, sind akustisch transversal gekoppelte Filter, z.B. symmetrisch betriebene Transversalmoden-gekoppelte Resonatorfilter (auch TCR-Filter - transversly coupled resonator filter) der in "1996 IEEE Ultrasonics Symposium - 47 - 51" beschriebenen Art.

Gemäß der Fig. 2 auf S. 48 dieses Dokuments sind die Ein- oder Ausgangswandler längs ihrer Longitudinalen, d.h. in Richtung der akustischen Spur gesplittet, die so erhaltenen Teilwandler sind elektrisch seriell verschaltet. Dadurch kann das kapazitive Übersprechen zwischen den gesplitteten Teilwandlern und dem in der benachbarten akustischen Spur direkt angrenzenden Wandlerelement kompensiert werden. Dies erfordert den symmetrischem Betrieb an mindestens einem Filtertor, d.h. zumindest am Ein- oder Ausgangswandler. In diesem Fall hebt sich aufgrund der unterschiedlicher Polarität der anliegenden Spannungen sowie des gleichen Betrags der Ersatzkapazität das Übersprechen auf. Als Nachteil erhöht sich die Impedanz der entsprechenden Anschlüsse auf den doppelten Ausgangswert.

Weitere typische Filter, die durch elektromagnetisches Übersprechen in ihrer Sperrselektion nachteilig beeinflußt werden, sind die z.B. durch das Dokument DE-OS 40 18 784 bekannten Z-Weg-Filter, die auf getrennten akustischen Spuren angeordnete Ein- und Ausgangswandler über entsprechend geneigte Reflektoren miteinander koppeln. Das genannte Dokument schlägt eine Verschaltung von zwei Teilfiltern in Form einer Halbbrücke vor, bei der sich elektrische Signale auslöschen und akustische Signale durch geeignete zusätzliche Phasenverschiebung konstruktiv überlagern.

Wesentlicher Nachteil dieser Filter ist ein um einen Faktor 2 erhöhter Platzbedarf und eine äußerst aufwendige und komplizierte Padstruktur.

Ein akustisches Oberflächenwellenfilter mit Kompensation kapazitiven Übersprechens zwischen den Wandlern ist aus GB 1 427 226 A bekannt.

Bei Inline-Filtern, d.h. bei Filtern deren Ein- und Ausgangswandler in einer gemeinsamen akustischen Spur angeordnet sind, wird das elektromagnetische Übersprechen durch relativ großen Wandlerabstand und die Minimierung "heißer" d.h. signalführender Wandlerflächen klein gehalten.

Der vorliegenden Erfindung liegt die Aufgabe zugrunde, ein akustisches OFW-Filter mit zumindest zwei elektromagnetisch gekoppelten Wandlern zu schaffen, bei dem das kapazitive und induktive Übersprechen kompensiert ist, und das so eine im Vergleich zu den bekannten Filtern erheblich verbesserte Sperrselektion besitzt ohne die Impedanz zu erhöhen.

Diese Aufgabe wird erfindungsgemäß gelöst durch ein OFW Filter mit den Merkmalen von Anspruch 1. Vorteilhafte Ausgestaltungen der Erfindung gehen aus den Unteransprüchen hervor.

Die Erfindung sieht ein akustisches Oberflächenwellenfilter vor, das symmetrisch betreibbar ist, das elektromagnetisch verkoppelte Interdigitalwandler in einander benachbarten akustischen Spuren aufweist, bei dem zumindest einer der elektromagnetisch verkoppelten Wandler in parallel geschaltete Teilwandler zerlegt ist, wobei die Teilwandler und Stromschienen der Wandler so angeordnet sind, daß bei symmetrischem Betrieb die Übersprechkapazitäten zwischen benachbarten Stromschienen und IDT Wandlern am entsprechenden Tor an betragsmäßig gleichen, jedoch mit unterschiedlichen Vorzeichen versehenen Spannungen anliegen und so abgeglichen sind. Der mindestens eine Interdigitalwandler ist so in Teilwandler zerlegt und die Führung von Stromanschlußschienen der Wandler so modifiziert, daß außerdem die Flußrichtungen der magnetischen Verkopplungen zwischen den Teilwandlern und mindestens einem Wandler der benachbarten akustischen Spur entgegengesetzt gerichtet sind, so daß sich die induktiven Übersprech-beiträge gegenseitig aufheben. Auf diese Weise sind die beiden Hauptursachen für das Übersprechen des OFW Filters ausgeschaltet und das Übertragungsverhalten verbessert.

In der Regel wird in einem der Teilwandler durch die modifizierte Führung der Stromschienen die Polarität der elektrischen Ansteuerung vertauscht. Die gewünschte akustische Funktionsweise des Filters wird dabei durch Spiegelung des diesbezüglichen Teilwandlers parallel zur bevorzugten akustischen Ausbreitungsrichtung, d.h. durch Spiegelung an seiner Längsachse, aufrechterhalten.

Die Vertauschung der Polarität der elektrischen Ansteuerung ist auch erzielbar, wenn ein Teilwandler gegen den anderen Teilwandler um ein ungeradzahliges Vielfaches der halben Wellenlänge der akustischen Oberflächenwelle verschoben ist.

Weitere Merkmale eines Oberflächenwellenfilters mit Kompensation von kapazitiven und/oder induktiven Übersprechbeiträgen sind in Figuren erläutert.

Es zeigt:
- Fig. 2:: in schematischer Darstellung ein kapazitiv entkoppeltes zweispuriges Filter;
- Fig. 3:: in schematischer Darstellung ein kapazitiv und induktiv entkoppeltes Z-Weg-OFW-Filter;
- Fig. 4:: ein erfindungsgemäßes Filter, bei dem Eingangswandler und Ausgangswandler jeweils in parallel geschaltete Teilwandler zerlegt sind; und
- Fig. 5:: ein erfindungsgemäßes Inline-Filter mit in longitudinaler Richtung nebeneinander angeordneten Eingangswandler und Ausgangswandler;
- Fig. 6:: ein Filter höherer Ordnung auf der Basis von in Figur 2 gezeigten Teilstrukturen mit kompensierter kapazitiver Kopplung;
- Fig. 7:: ein Filter höherer Ordnung mit akustisch gekoppelten Spuren und kompensierter kapazitiver Kopplung.

Beim Filter gemäß Figur 2, das nicht erfindungsgemäß ist, ist ein Wandler, beispielsweise der Eingangswandler longitudinal geteilt, die Teilwandler aber nicht in Serie, sondern parallel verschaltet. Die dabei auftretende Kreuzung der Leiterbahnen wird durch eine Doppelbondung zum Gehäuse aufgelöst. Bei symmetrischem Betrieb am Filtereingang - es wird sowohl ein positives als auch ein negatives Signal angelegt - bauen sich zwischen den Stromschienen der Teilwandler a und a' und der Stromschiene 6 des hier einzigen Wandlers der benachbarten akustischen Spur die beiden Ersatzkapazitäten C4 und C4' auf, die ungefähr die gleiche Größe aufweisen und sich aufgrund der unterschiedlichen Polaritäten gegenseitig kompensieren. Im Gegensatz zu bekannten seriellen Verschaltungen in Teilwandler bleibt hier die Eingangsimpedanz durch parallele Verschaltung zweier Teilwandler einer Impedanz von jeweils 2 Z_{w} auf dem Referenzwert Z_{w} erhalten. Die Impedanz am Filtereingang wird also durch die Teilwandler nicht erhöht. Die Kompensation der Kapazitäten C4 und C4' bleibt auch erhalten, wenn der Ausgang nicht symmetrisch betrieben wird, also wenn ein Anschluß auf Festpotential (Masse) gelegt wird.

In einem in Fig. 3 gezeigten Beispiel, das ebenfalls nicht erfindungsgemäß ist, sind wie in Figur 1 das kapazitive und das induktive Übersprechen durch strichliniert angedeutete Ersatzschaltbildkapazitäten C, C' bzw. durch Magnetfeldlinien H, H' symbolisiert, die teils durch Pfeile gekennzeichnete benachbarte Stromflußlinien umschlingen.

Die von der jeweiligen Stromflußrichtung abhängigen Magnetflußrichtungen in den Bereichen der Wandler bzw. Teilwandler sind durch Symbole "⊙" und "⊕" angedeutet, wobei - betrachtet in Zeichenebene - das Symbol "⊙" für die nach oben und entsprechend das Symbol "⊕" für die nach unten gerichtete Magnetflußrichtung steht.

Beim Z-Weg-Filter nach Fig. 3 sind in zueinander parallelen akustischen Spuren Ein- und Ausgangswandler 10, 11 angeordnet, die über entsprechende zur Hauptausbreitungsrichtung der akustischen Spuren geneigte Reflektoren 12, 13 miteinander gekoppelt sind.

Im Filter nach Figur 3 sind beide Wandler, deren Stromanschlußbahnen mit 14, 15 bzw. 16, 17, 18 bezeichnet sind, longitudinal, d.h. betrachtet in Richtung der Hauptausbreitungsrichtung der Oberflächenwellen, in Teilwandler a, a' bzw. in b, b' aufgetrennt und ihre Stromanschlußbahnen 14, 15 bzw. 16, 17, 18 so geführt, daß in einem der Teilwandler die Polarität der elektrischen Ansteuerung vertauscht und damit Stromflußschleifen unterschiedlicher Magnetflußorientierung - siehe die Magnetfeldlinien H, H'- erhalten werden, die zur gegenseitigen Aufhebung der induktiven Übersprechbeiträge führen.

Die Parallel-Schaltung der Teilwandler a, a' und die Serien-Schaltung der Teilwandler b, b' ergibt schließlich eine kapazitive Halbbrücke für die Übersprechkapazitäten C, C', die bei symmetrischem Betrieb am entsprechenden Tor bzw. Ein- oder Ausgangswandler abgeglichen ist.

Die Übersprechteilbeiträge an sich hängen dabei im wesentlichen von der konkreten Fingerstruktur der Wandler und von der Struktur der Stromanschlußbahnen ab, was bei der Auftrennung der Wandler in die Teilwandler zu berücksichtigen ist. Die Parallel-Schaltung der Teilwandler bietet im Unterschied zur Serien-Schaltung günstigere akustische Wandler-Widerstände und zusätzlich niedrigere Widerstände der Stromanschlußbahnen und damit niedrigere Verluste. Die Serien-Schaltung hingegen zeichnet sich durch geringeren Platzbedarf und einfachere Führung von Stromanschlußbahnen aus.

Beim Z-Weg-Filter nach Fig. 4, das eine erfindungsgemäße Filterrealisierung zeigt, ist jeweils longitudinal der Eingangswandler 20 in Teilwandler d, d' und der über Reflektoren 21, 22 hiermit gekoppelte Ausgangswandler 23 in Teilwandler e, e' aufgetrennt. Vorzugsweise kann anstatt Spiegelung der eine Teilwandler gegen den anderen Teilwandler um ein ungeradzahliges Vielfaches der halben Wellenlänge der akustischen Oberflächenwelle verschoben werden.

Die Stromanschlußbahnen 24, 25 und 26, 27 sind wiederum so geführt, daß in einem der Teilwandler die Polarität der elektrischen Ansteuerung vertauscht und damit unterschiedliche Magnetflußrichtungen H, H' erhalten werden, die zur Kompensation der induzierten Übersprechbeiträge führen.

In diesem Ausführungsbeispiel sind beide Teilwandler-Paare parallel geschaltet. Die so geschaffene kapazitive Halbbrücke für die Übersprechkapazitäten C, C' ist bei symmetrischem Betrieb am Tor 23 wieder abgeglichen.

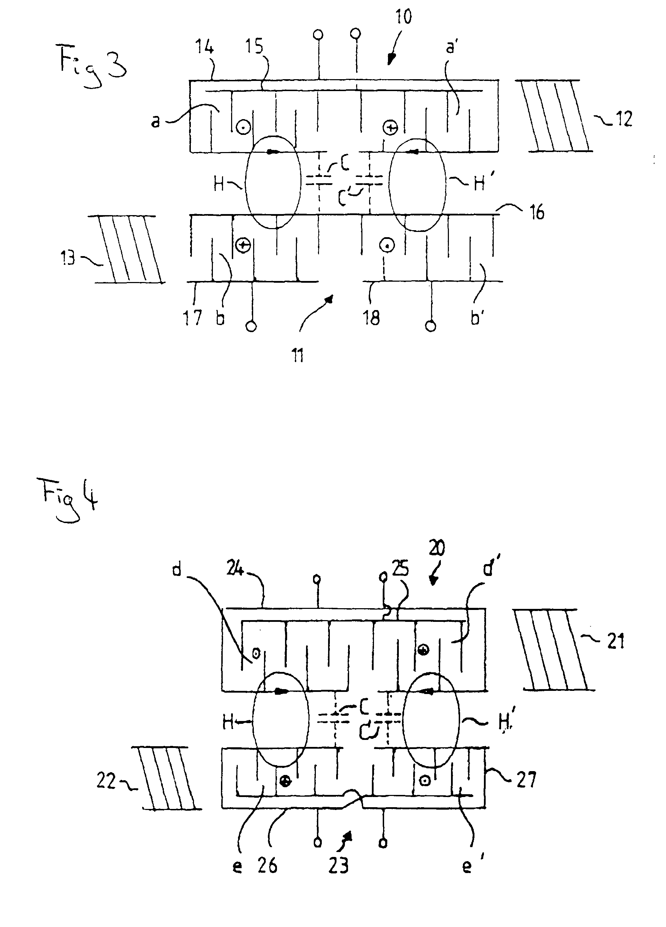

Fig. 5 zeigt eine weitere erfindungsgemäße Filterrealisierung. Beim Inline-Filter nach Fig. 5, d.h. bei einem Filter mit in gleicher akustischer Spur angeordneten Ein- und Ausgangswandlern 30 bzw. 31, ist nur einer der beiden Wandler, hier der Eingangswandler 30, transversal in Teilwandler f, f' aufgeteilt.

Der Teilwandler und die Führung der Stromanschlußbahnen 32, 33 bewirken wiederum im vorstehend bereits erläuterten Sinne einen Abgleich der Übersprechkapazitäten C, C' und die Kompensation der induktiven Übersprechbeiträge.

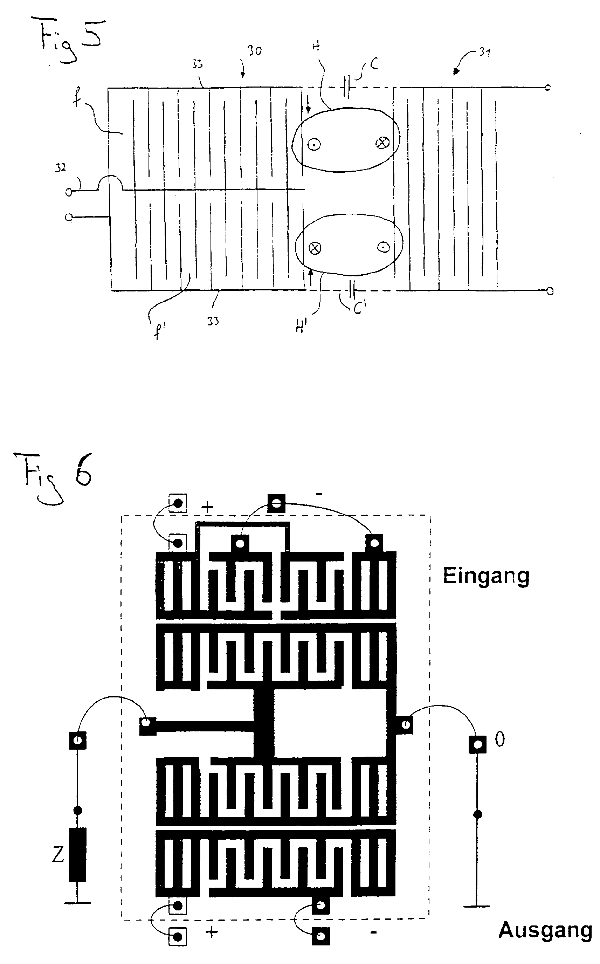

Figur 6 zeigt, wie die Wandler (z.B. die Wandler gemäß Figur 2) zu einem Filter höherer Ordnung kaskadiert werden können. Ein- und Ausgangsseite des Filters sind wie in Figur 2 aufgebaut. Die Kopplung zwischen den Teilstrukturen erfolgt rein elektrisch über die beiden mittleren unsymmetrisch betriebenen Wandler. Die an die zwei mittleren Wandler angeschlossene Impedanz Z dient hier zur Abstimmung des Übertragungsverhaltens des Gesamtfilters. Die Aufteilung in parallel verschaltete Teilwandler auf der hier als Eingang E bezeichneten Seite kompensiert das kapazitive Übersprechen. Die Blindkapazität C7 führt nicht zu einem Übersprechen, da die mittlere Stromschiene auf Masse liegt.

Werden weitere ein- und ausgangsseitig unsymmetrisch betriebene Filter in die Struktur nach Figur 2 oder 6 eingefügt und gegebenenfalls mit geeigneten Impedanzen gegen Masse abgeschlossen, werden Filter mit noch höherer Ordnung erhalten.

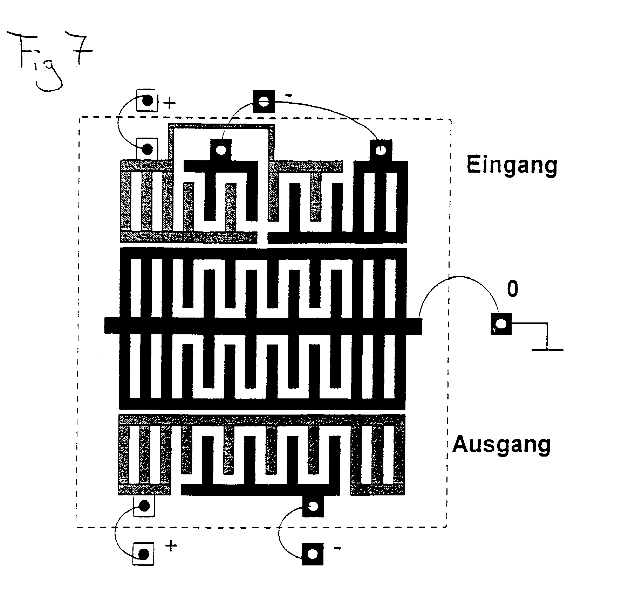

Figur 7 zeigt ein Filter, bei dem alle Spuren akustisch und nicht elektrisch gekoppelt sind.

Auch hier läßt sich die Filterordnung durch Aufnahme von zusätzlichen Resonatorspuren erhöhen.

Die Erfindung ist nicht auf die vorstehenden Ausführungsbeispiele beschränkt, sondern wird durch die Merkmale in Anspruch 1 definiert. Es sind beliebige Kombinationen von longitudinaler/transversaler Wandleraufteilung, Parallel-/Serien-schaltung der Teilwandler und Kombinationen von akustischer Inline-/Transversalkopplung möglich, soweit sie die in Anspruch 1 beanspruchten Merkmale aufweisen.

Die Erfindung ist auch bei TCF Filtern (Transversly Coupled Resonator Filters) einsetzbar, bei der die Oberflächenwelle nicht über geneigte Reflektoren, sondern direkt durch akustische Kopplung in die benachbarten Spuren übertragen wird.

## Patentansprüche

1. Akustisches Oberflächenwellenfilter,
- das beidseitig symmetrisch betreibbar ist,
- mit elektromagnetisch verkoppelten Interdigitalwandlern (20, 23),
- bei dem mindestens einer der elektromagnetisch verkoppelten Interdigitalwandler (20, 23) in parallel geschaltete Teilwandler (d, d'; f, f') zerlegt ist,
- bei dem die Teilwandler und Stromanschlußschienen der Interdigitalwandler (20, 23) so angeordnet sind, daß bei symmetrischem Betrieb die Übersprechkapazitäten zwischen zueinander gewandten Stromanschlußschienen der elektromagnetisch verkoppelten Interdigitalwandler am entsprechenden Tor einander betragsmäßig annähernd gleichen, jedoch an Spannungen entgegengesetzter Polaritäten anliegen und so abgeglichen sind,
- wobei die Stromanschlußschienen (24, 25; 26, 27) der elektromagnetisch verkoppelten Interdigitalwandler so geführt sind, daß magnetische Verkopplungen mit entgegengesetzt gerichteten Magnetflußrichtungen (H, H') erhalten werden, die zur Kompensation der induzierten induktiven Übersprechbeiträge führen.

2. Oberflächenwellenfilter nach Anspruch 1,
bei dem die parallel geschalteten Teilwandler (d, d') in longitudinaler Richtung nebeneinander angeordnet sind.

3. Oberflächenwellenfilter nach Anspruch 1 oder 2,
bei dem beide Interdigitalwandler (20; 23) in parallel geschaltete Teilwandler (d, d'; e, e') zerlegt sind.

4. Oberflächenwellenfilter nach einem der Ansprüche 1 bis
bei dem einer der elektromagnetisch gekoppelten Interdigitalwandler in parallel geschaltete Teilwandler zerlegt ist, und bei dem der mit ihm gekoppelte Interdigitalwandler in seriell geschaltete Teilwandler zerlegt ist.

5. Oberflächenwellenfilter nach Anspruch 1 bis 4,
bei dem ein Teilwandler des zerlegten Interdigitalwandlers vom anderen Teilwandler dieses Wandlers um ein ungeradzahliges Vielfaches der halben Wellenlänge der akustischen Oberflächenwelle beabstandet ist.

6. Oberflächenwellenfilter nach Anspruch 1,
bei dem der zumindest eine Interdigitalwandler in transversaler Richtung in Teilwandler (f, f') zerlegt ist.

## Claims

1. Surface acoustic wave filter,
- which can be operated in a balanced manner on both sides,
- having electromagnetically coupled interdigital transducers (20, 23),
- in which at least one of the electromagnetically coupled interdigital transducers (20, 23) is broken down into parallel-connected transducer elements (d, d'; f, f'),
- in which the transducer elements and electrical connecting rails for the interdigital transducers (20, 23) are arranged such that, during balanced operation, the crosstalk capacitances between mutually facing electrical connecting rails of the electromagnetically coupled interdigital transducers have approximately the same magnitudes as one another at the corresponding port, but have voltages of opposite polarities applied to them, and are thus matched,
- with the electrical connecting rails (24, 25; 26, 27) of the electromagnetically coupled interdigital transducers being routed such that magnetic couplings are produced with magnetic flux direction (H, H') in opposite directions, which lead to compensation for the induced inductive crosstalk contributions.

2. Surface acoustic wave filter according to Claim 1, in which the parallel-connected transducer elements (d, d') are arranged alongside one another in the longitudinal direction.

3. Surface acoustic wave filter according to Claim 1 or 2, in which both interdigital transducers (20; 23) are broken down into parallel-connected transducer elements (d, d'; e, e').

4. Surface acoustic wave filter according to one of Claims 1 or 2, in which one of the electromagnetically coupled interdigital transducers is broken down into parallel-connected transducer elements, and in which the interdigital transducer which is coupled to it is broken down into series-connected transducer elements.

5. Surface acoustic wave filter according to Claims 1 to 4, in which one transducer element of the broken-down interdigital transducer is separated from the other transducer element of this transducer by an odd-numbered multiple of half the wavelength of the surface acoustic wave.

6. Surface acoustic wave filter according to Claim 1, in which the at least one interdigital transducer is broken down into transducer elements (f, f') in the transverse direction.

## Revendications

1. Filtre acoustique à ondes de surface,
- qui peut fonctionner symétriquement des deux côtés,
- ayant des transducteurs (20, 23) interdigités et couplés électromagnétiquement,
- dans lequel au moins l'un des transducteurs (20, 23) interdigités et couplés électromagnétiquement est décomposé en des sous-transducteurs (d, d'; f, f') montés en parallèle,
- dans lequel les sous-transducteurs et les rails de connexion de courant des transducteurs (20, 23) interdigités sont disposés de sorte qu'en fonctionnement symétrique, les capacités de diaphonie entre des rails de connexion de courant, tournés l'un vers l'autre, des transducteurs interdigités et couplés électromagnétiquement s'appliquent à la porte correspondante en étant à peu prés égales en valeur absolue, mais de polarité opposée en tension et ainsi se compensent,
- les rails (24, 25, 26, 27) de connexion de courant des transducteurs interdigités électromagnétiquement étant guidés de façon à obtenir des couplages magnétiques, ayant des directions (H, H') de flux magnétique de sens opposé, qui entraînent la compensation des contributions de diaphonie inductives induites.

2. Filtre à ondes de surface selon la revendication 1, dans lequel les sous conducteurs (d, d') montés en parallèle sont disposés côte-à-côte dans des directions longitudinales.

3. Filtre à ondes de surface selon la revendication 1 ou 2, dans lequel les deux transducteurs (20, 23) interdigités sont décomposés en des sous transducteurs (d, d'; e, e') montés en parallèle.

4. Filtre à ondes de surface selon la revendication 1 à 2, dans lequel l'un des transducteurs interdigités et couplés électromagnétiquement est décomposé en des sous transducteurs montés en parallèle et dans lequel le transducteur interdigité qui lui est couplé est décomposé en des sous transducteurs montés en série.

5. Filtre à ondes de surface selon les revendications 1 à 4, dans lequel un sous transducteur du transducteur interdigité décomposé est à distance de l'autre sous transducteur de ce transducteur, d'un multiple impair de la demi longueur d'onde de l'onde de surface accoustique.

6. Filtre à ondes de surface selon la revendication 1 dans lequel au moins un transducteur interdigité est décomposé dans la direction transversale en sous transducteurs (f, f').
